# EUROPEAN PATENT SPECIFICATION

(11) **EP 1 573 830 B1**
(45) Date of publication and mention of the grant of the patent: **09.11.2016**
(21) Application number: 03813237.9
(22) Date of filing: 05.12.2003
(51) Int. Cl.: H01L 51/00

(54) **ORGANIC ELECTROLUMINESCENT COMPONENT WITH TRIPLET EMITTER COMPLEX**
ORGANISCHES ELEKTROLUMINESZIERENDES BAUTEIL MIT TRIPLET-EMITTER KOMPLEXES
COMPOSANT ELECTROLUMINESCENT ORGANIQUE COMPRENANT UN COMPLEXE PRESENTANT UN ETAT TRIPLET EMISSIF

(30) Priority: 13.12.2002 EP 02102754
(43) Date of publication of application: 14.09.2005
(73) Proprietor: Philips Intellectual Property & Standards GmbH, 20099 Hamburg (DE); Koninklijke Philips N.V., 5656 AE Eindhoven (NL)
(72) Inventor: BOERNER, Herbert, Friedrich, 52066 Aachen (DE)
(74) Representative: de Haan, Poul Erik
(86) International application number: PCT/IB2003/005744
(87) International publication number: WO 2004/055921

(56) References cited:
- WO-A-01/93642
- WO-A-02/074015
- DE-A- 4 428 450
- V. ADAMOVICH ET AL: "High efficiency single dopant white electrophosphorescent light emitting diodes" NEW JOURNAL OF CHEMISTRY, vol. 26, 12 August 2002 (2002-08-12), pages 1171-1178, XP008037151
- HOLMES R J ET AL: "Blue organic electrophosphorescence using exothermic host-guest energy transfer" APPLIED PHYSICS LETTERS, AMERICAN INSTITUTE OF PHYSICS. NEW YORK, US, vol. 82, no. 15, 14 April 2003 (2003-04-14), pages 2422-2424, XP012033750 ISSN: 0003-6951

## Description

The invention relates to an organic electroluminescent component for luminous displays, lights, solid-state image intensifiers, monitors or display screens.

LEDs according to the prior art are generally semiconductor diodes, i.e. diodes whose construction involves the use of inorganic semiconductors such as doped zinc sulfide, silicon, germanium or III-V semiconductors, e.g. InP, GaAs, GaAlAs, GaP or GaN with appropriate doping.

For a number of years, work has been carried out to develop luminescent radiation sources whose emissive material is not an inorganic semiconductor, but instead an organic electrically conductive material.

Document V. Adamovich et al, New Journal of Chemistry, Vol. 26, p-1171-1178 (2002) and WO 02/074015A are closely related prior art documents.

Electroluminescent components with light-emitting layers based on organic materials are superior in terms of some properties to light sources made of inorganic materials. One advantage is that they are readily shapeable and have a high elasticity, which allows new applications e.g. for luminous displays and display screens. These layers can be readily produced as large-area, flat and very thin layers requiring the use of little material.

Organic electroluminescent components can therefore be used as large-area light sources for a range of applications, in the field of display elements, display-screen technology and lighting technology.

They are also distinguished by a significantly high brightness and, at the same time, a low drive voltage.

The color of the emitted light can furthermore be varied in wide ranges, from about 400 nm to about 650 nm, by selection of the luminescent substance. These colors have outstanding luminosity.

Combinations of electrically conductive organic materials with metallo-organic compounds of rare-earth metals and other transition metals having an emissive triplet state, so-called triplet emitter complexes, have therefore already been used for luminescent radiation sources.

In these triplet-emitter complex compounds, the energy levels are arranged relative to one another so that, according to the spin selection rules, there are at least two partially allowed possibilities for radiative transitions between two energy levels.

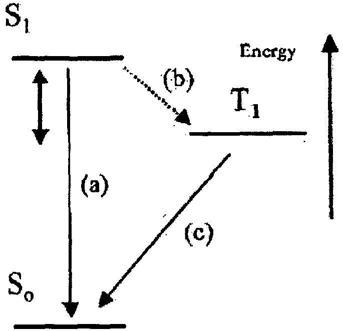

The energy levels of the triplet emitter complexes comprise a ground state So, in which all the valence bands are filled and all the conduction bands are empty. The lowest two excited states are the first excited singlet exciton state S₁ and the first triplet state T₁. The triplet state is lower than the singlet state by the value of the exchange energy. Radiative transition a) is a strong and efficient singlet exciton transition - a luminescent or fluorescent transition.

Conversely, transition c) from T₁ to the ground state So is normally spin-forbidden and therefore slow and inefficient. Spin-orbit coupling takes place in triplet emitter complexes, which leads to mixing of the spin states and makes transition c) from the triplet exciton state T₁ to the ground state So - a phosphorescent transition - into a partially allowed transition. Transition b) stands for intersystem crossing.

The luminous efficiency of organic electroluminescent components can be increased by using triplet emitter complex compounds, because not only the singlet excitons (as in the prior art), but also the triplet excitons can then be used for the optical excitation by the excitons created when electrons and holes recombine.

DE 4428450 discloses an organic electroluminescent component having a layer composite, comprising a) a substrate layer, b) a first transparent electrode layer, c) one or more optoelectronically functional layers having c.1) optionally one or more p-conductive organic materials with one or more singlet states and one or more triplet states and c.2) a luminescent material with one or more metallo-organic complexes of a rare-earth metal ion with organic ligands, the rare-earth metal ion having an emissive state and the organic ligands having one or more singlet states and one or more triplet states, and c.3) one or more n-conductive organic materials with one or more singlet states and one or more triplet states and d) a second electrode, wherein the lowest-energy triplet state of the ligands is lower than the lowest-energy triplet state of the n-conductive and/or p-conductive organic materials and higher than the emissive state of the rare-earth metal ion.

One disadvantage of the aforementioned components is their low efficiency. The low optical efficiency entails increased heating of the components due to charge transport and nonradiative transitions, which eventually destroys the components.

There is therefore a persistent need to improve the efficiency and life of organic electroluminescent components having triplet emitter complex compounds.

It is therefore an object of the invention to provide an organic electroluminescent component, with an electrically conductive organic material as the matrix and a metallo-organic metal complex compound as the emitter, which has a high luminous efficiency and a long life.

According to the invention, the object is achieved by an organic electroluminescent component having a layer composite, which comprises
a) a first transparent electrode layer,
b) a mixing layer having
   b.1) a matrix of a conductive organic material with one or more singlet states and one or more triplet states, selected from the group: p-conductive and n-conductive materials,
   b.2) in this matrix, a light-emitting material which contains a metallo-organic complex compound with an emissive triplet state, and
c) a second electrode,
wherein the lowest-energy triplet state of the conductive organic material is higher than the emissive triplet state of the metallo-organic complex compound by an energy difference Eₜ.

The invention is based on the fundamental concept that the luminous efficiency of an organic electroluminescent component will be increased if energy transfer from the emissive triplet state of the metallo-organic complex compound to the matrix is prevented. The probability of an undesired radiationless transition in the matrix is reduced, and more triplet excitons are made usable for the light excitation.

An organic electroluminescent component according to the invention is therefore distinguished by a surprisingly increased luminous efficiency. Furthermore, it has very good thermal stability and can be produced by straightforward methods.

In the scope of the present invention, it is preferable for the energy difference to be Eₜ ≥0.228 eV (2000 cm⁻¹)

In such an organic electroluminescent component having a mixing layer, which contains a conductive organic material with one or more singlet states and one or more triplet states, selected from the group: p-conductive and n-conductive materials, and a metallo-organic complex compound with an emissive triplet state, with said relative positioning of the energy states, the processes that give rise to luminescence have a particularly high efficiency.

In the scope of the present invention, the conductive organic material comprises a structural element which is a benzene ring substituted with an organic substituent R- in the meta position.

In the scope of the present invention, it is particularly preferable for the conductive organic material to comprise a structural element which is a biphenyl substituted with an organic substituent R- in the meta position.

In may furthermore be preferable for the conductive organic material to comprise a structural element which is a biphenyl multiply-substituted in the meta position.

The conductive organic material may be selected from the group: molecularly doped organic polymers, semiconducting conjugated polymers, intrinsically conductive organic polymers, oligomers and conductive organic monomers, and mixtures thereof.

It is preferable for the substituent R- to be selected from the group of organic substituents: phenyl and derivatives, arylamine and derivatives, oxadiazole and derivatives, triazole and derivatives, triphenylamine and derivatives, carbazole and derivatives, oxadiazole and derivatives, triazine and derivatives, fluorene and derivatives, hexaphenylbenzene and derivatives, phenanthroline and derivatives, pyridine and derivatives.

These and other aspects of the invention are apparent from and will be elucidated with reference to the embodiments described hereinafter.

In the drawings:

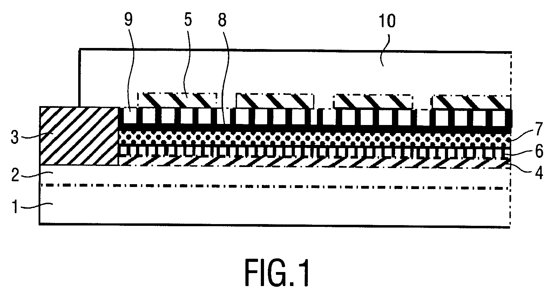

Fig. 1 shows the basic structure of an embodiment of an organic electroluminescent component according to the invention.

An organic electroluminescent component according to the invention generally contains a complex layer system of individual layers applied above one another and sometimes next to one another, which fulfill different functions.

The basic structure for the sequence of the layers and their functions is as follows:
- 1: substrate
- 2: adhesion promoting layer
- 3: contact terminals
- 4: first electrode
- 5: second electrode
- 6: hole-transporting layer
- 7: mixing layer
- 8: hole-blockade layer
- 9: electron-transporting layer
- 10: protective layer.

This structure represents the most general case and may be simplified by omitting particular layers, so that one layer may perform several tasks.

In the simplest case, the organic electroluminescent component consists of two electrodes, between which there is an organic mixing layer which fulfills all the functions - including that of the light emission.

One or more electron-injection and/or electron-transport layers may also be arranged between the electroluminescent mixing layer and the positive electrode. One or more hole-injection and/or hole-transport layers may likewise be arranged between the electroluminescent mixing layer and the negative electrode.

For organic electroluminescent components with triplet emitter compounds according to the invention, it is preferable to use a structure in which the anode is followed by a layer of a hole-conductive material, which facilitates the injection of holes from the anode and transports the holes into a mixing layer. The latter consists of the light-emitting molecules of the triplet emitter complex, embedded in a matrix made of a hole conductor. Since the holes are the majority charge carriers in almost all cases, the mixing layer should be followed by a hole-blockade layer in which the holes are weakly injected and their mobility is low. The hole-blockade layer is followed by an electron-transport layer, the thickness of which is dimensioned so that it minimizes the emission quenching by the metallic cathode.

According to another embodiment of the invention, the mixing layer contains a matrix of an electron-conductive material in addition to the triplet emitter complex.

The embodiment shown in Fig. 1 comprises a first electrode 4 made of ITO with contact terminals 3, an electroluminescent mixing layer 7, a hole-transporting layer 6, an electron-transporting layer 9, a hole-blockade layer 8 and a second electrode 5 made of Al. The organic electroluminescent component is furthermore covered with a protective layer 10. It is preferably applied to an optically transparent substrate 1 by means of an adhesion-promoting layer 2 of SiO₂.

The layer composite may also be arranged on a substrate made of glass, quartz, ceramic, synthetic resin or a transparent flexible plastic film. Examples of suitable plastics are polyimides, polyethylene terephthalates and polytetrafluoroethylenes.

The electroluminescent mixing layer 7 may contain a conductive monomer, oligomer or polymer as the matrix. Depending on the type of organic material which is used in the electroluminescent layer 7, the devices will be referred to as SMOLEDs (small molecule organic light emitting diodes), OLEDs or polyLEDs.

The electroluminescent mixing layer 7 may be subdivided into a plurality of color pixels, which emit light in the colors: red, green and blue. In order to produce colored light, the material in the electroluminescent layer 7 may be doped with fluorescent dyes, or an appropriately emitting triplet emitter complex compound may be used as the material in the electroluminescent layer 4. In another embodiment, a triplet emitter complex compound which emits light in a broad wavelength range is used in the electroluminescent layer 4. Light in one of the three primary colors: red, green or blue, is produced from this broadband emission by color filters.

Metals, metal oxides or electrically conductive organic polymers with a high work function for electrons are suitable as a material for the transparent anode, from which holes are injected into the p-conductive layer. Examples are thin, transparent layers of indium-doped tin oxide (ITO), gold or polyaniline.

Materials with a low work function are used as a material for the cathode, since electrons have to be injected into the n-conductive layer by the cathode. Examples of such metals are aluminum, magnesium and alloys of magnesium with silver or indium as well as calcium.

The organic electroluminescent component comprises a mixing layer having a matrix of a conductive organic material with one or more singlet states and one or more triplet states, selected from the group: p-conductive and n-conductive organic materials, and, in this matrix, a light-emitting material which contains a metallo-organic complex compound with an emissive triplet state, wherein the lowest-energy triplet state of the conductive organic material is higher than the emissive triplet state of the metallo-organic complex compound by an energy difference Eₜ.

It is not the absolute values of the energy levels, but instead their positioning relative to one another which is important when selecting the components for the matrix and for the triplet emitter complex.

The conductive organic materials, with one or more singlet states and one or more triplet states, selected from the group: p-conductive and n-conductive organic materials, which are used according to the invention are preferably conjugated dienes with alternating single and double bonds, which contain a biphenyl substituted in the meta position as a structural element.

Conjugated dienes have a delocalized π electron system along the main chain. The delocalized electron system imparts semiconductor properties to the organic material and provides it with the possibility of transporting positive and/or negative charge carriers with a high mobility.

The optical and electronic properties of π-conjugated molecules are strongly dependent on the configuration of the main chain. Any reduction of the conjugative interaction is coupled with a drastic change in the optical and electronic properties of the material.

The influence of the meta substitution on the energy of the first triplet level in an organic material, which contains a biphenyl substituted in the meta position as a structural element of a conjugated diene, will firstly be demonstrated in respect of monomers and polymers, especially oligo-phenylene. 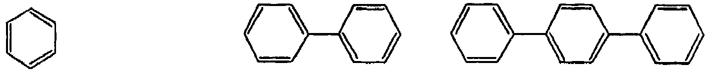 benzene: T1 = 3.658 eV (29500 cm⁻¹) biphenyl: T1 = 2.83 eV (22900 cm ⁻¹) p-terphenyl: T1 2.52 eV (20400 cm⁻¹) 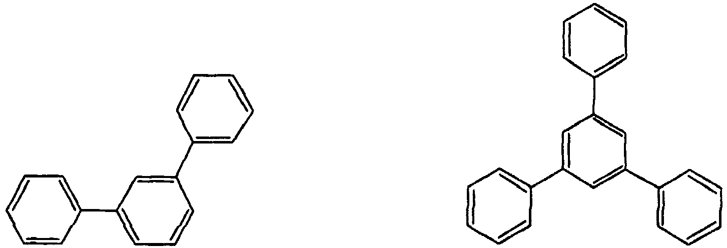 m-terphenyl: T1 = 2.79 eV (22500 cm ⁻¹) 1,3,5-triphenylbenzene: T1 = 2.79 eV (22500 cm⁻¹) 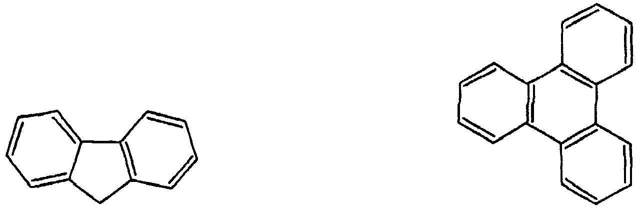 fluorene: T1 = 2.92 eV (23600 cm⁻¹) triphenylene: T1 = 2.92 eV (23600 cm⁻¹)

The triplet level decreases in the sequence benzene -> biphenyl -> para-terphenyl from 3.65 eV (29500 cm⁻¹) to 2.52 eV (20400cm⁻¹) which is too little for use in OLEDs with green or blue triplet emitters. When considering m-terphenyl, it can be seen that the triplet level at 2.79 eV (22500 cm⁻¹) is only slightly lower than that of biphenyl at 2.83 eV (22900 cm⁻¹)

Obviously, such coupling in the meta position leads to perturbation of the resonance between the pi electron systems of the benzene rings, and therefore to raising of the triplet level.

If another phenyl unit is coupled to the middle phenyl ring, then 1,3,5-triphenylbenzene is obtained, the positioning of the triplet level remaining unchanged.

As can be seen by comparing fluorene and triphenylene, coupling in the ortho position likewise has little or no influence on the triplet level.

If the principle of coupling in the meta position is logically applied to fluorene, then the bi- and tri-fluorene variants given below are obtained, for which a high triplet level comparable to that of fluorene is likewise achieved.

If this sequence is continued, then "poly-meta-fluorene" is obtained. 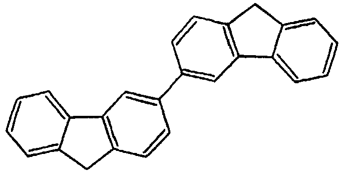 "meta-bi-fluorene"

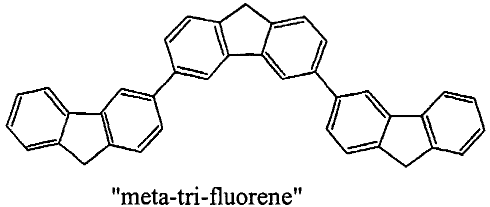

The same principle can also be applied to other polyphenyls.

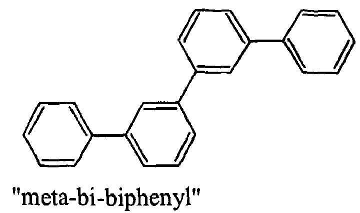

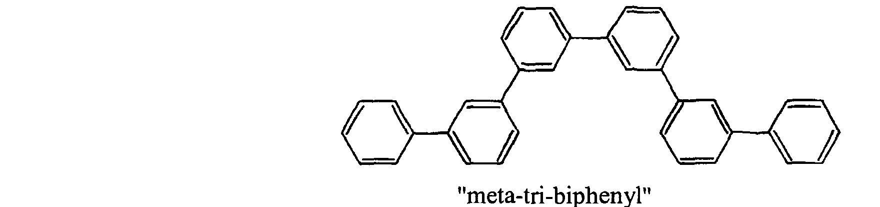

Application of the principle to hole conductors is preferred 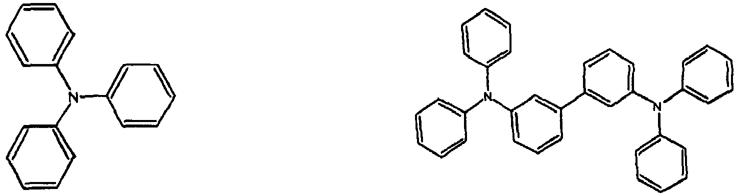 1.) triphenylamine: T1 = 3.03 eV (24500 cm⁻¹) 2.) 2 triphenylamine units coupled via the meta position 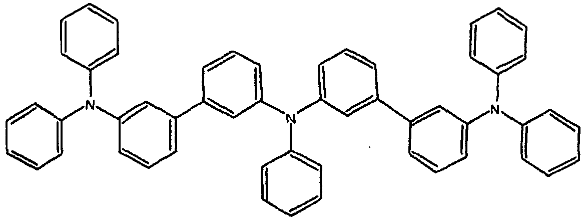 3.) 3 triphenylamine units coupled via the meta position 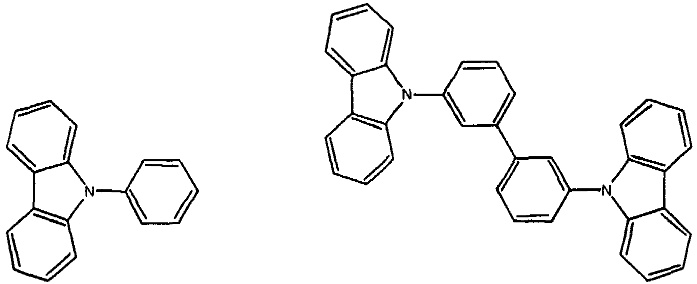 4.) 9-phenyl-9H carbazoles 5.) 2 phenyl-carbazole units coupled via the meta position

Triphenylamine is the building block for a whole range of excellent hole conductors. One of the best known is TPD, which can be regarded as consisting of two triphenylamine units that are coupled in the para position. This coupling gives rise to a central biphenyl unit in TPD, however, which connects the pi electrons well over the entire molecule. The result is a significant lowering of the triplet level: from 3.03 eV (24500 cm⁻¹) for triphenylamine to 2.38 eV (19200 cm⁻¹) for TPD. If the two triphenylamine units are coupled via the meta position of the two central phenyl rings (2.), however, then the triplet level remains almost the same. Further triphenylamine units may be added in the meta position (3.), without lowering the triplet level. In particular, a hole-conductive polymer with a high triplet can be obtained in this way.

The same principle can also be applied to other hole-conductive groups, for example the phenyl-carbazole group.

It is also possible to use electron-conductive materials in conjunction with triplet emitters. 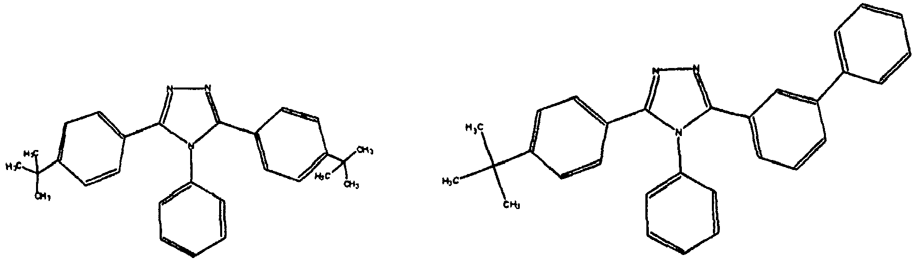 triazoles: T1 = 2.86 eV (23100 cm⁻¹) triazole unit with phenyl ring coupled via the meta position 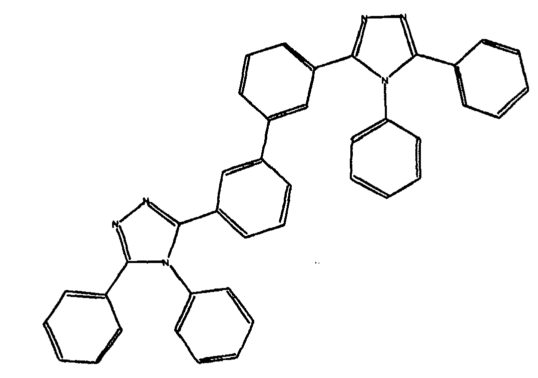 2 triazole units coupled via the meta position 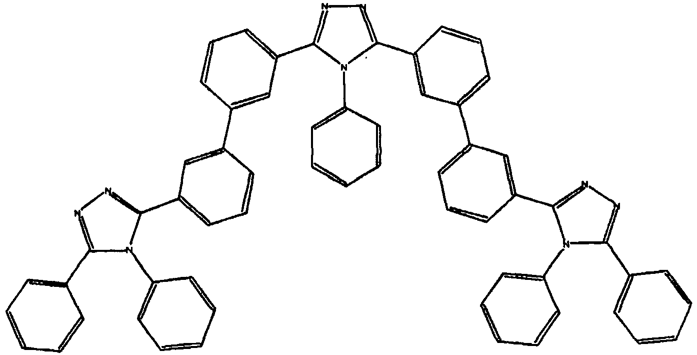 3 triazole units coupled via the meta position

Oxadiazoles and the triazole shown above, in which the triplet level is still quite high, are known electron conductors. If a phenyl group is inserted in the para position, however, then the triplet energy is drastically lowered. This loss is avoided by coupling via the meta position. As in the case of hole conductors, more triazole units may also be coupled via the meta position so that polymers with a high triplet are likewise obtained.

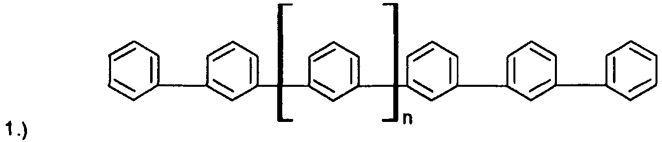

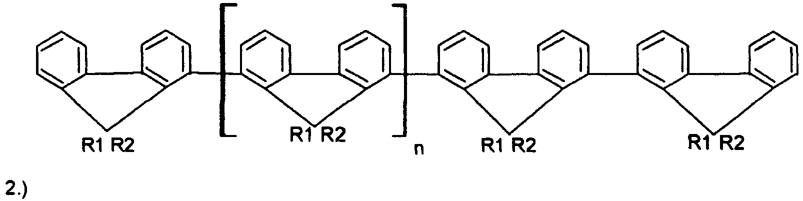

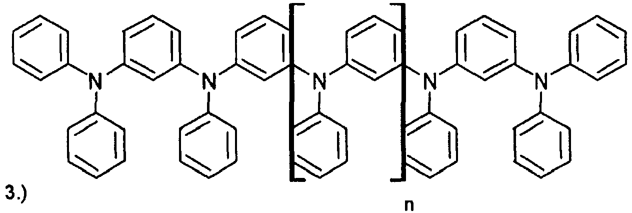

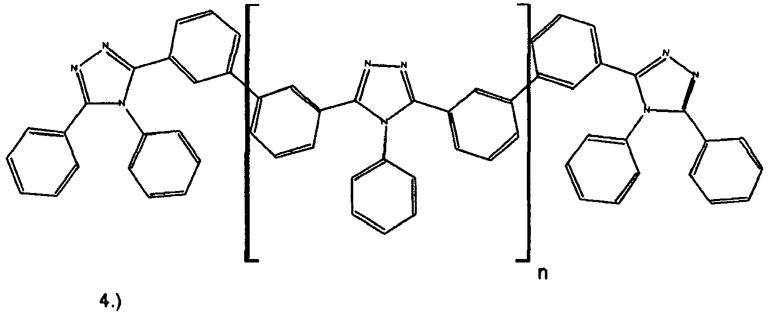

The principle of coupling via the meta position is thus used to produce polymers with a high triplet, the four examples showing only a small extract of the possible structures. 1.) and 2.) are structures which consist only of phenyl groups and are intended to have the predominantly electron-transport properties according to the invention. 3.) shows a prototypic hole conductor made of triphenylamine units; 4.) shows an electron conductor made of triazoles.

The mixing layer furthermore contains a light-emitting triplet emitter complex compound embedded in the matrix.

Metallo-organic complexes of rare-earth metals and platinum metals with organic oxygen, sulfur or nitrogen ligands are preferably used as the light-emitting triplet emitter complexes. In the scope of the present invention, the term metallo-organic complexes is intended to mean those complexes with said organic ligands in which binding takes place via the heteroatoms. Depending on the color intended for the emitted light, it is also possible to use a plurality of rare-earth metal complex compounds. It is also possible to use rare-earth metal complexes which are not sublimable or not electrically conductive.

It is preferable for the ligands of the rare-earth metal ion to be chelated oxygen, sulfur or nitrogen ligands. Such complexes are distinguished by intense energy transfer and the ability to represent pure colors.

Chelate complexes of rare-earth metals with the anions of aromatic carboxylic acids are particularly efficient, for example terbium benzoate, europium cinnamate, as well as picolinates, dipicolinates, dithiocarbamates or europium 8-hydroxyquinolate, or chelate complexes with aliphatic or aromatic acetyl acetonates and diketonates.

The rare-earth metal ion may, for example, be selected from the group: Eu²⁺, Eu³⁺, Tb³⁺, Tm³⁺, Dy³⁺, Sm³⁺ and Pr³⁺.

The platinum metal may, for example, be selected from the group: iridium³⁺ and Pt²⁺.

Red fluorescence can be produced with europium and samarium complexes, green fluorescence can be produced with terbium complexes and blue fluorescence can be produced with thulium and dysprosium complexes.

The concentration of said rare-earth metal complexes should not exceed 20 molar percent, so as not to affect the transport properties of the conductive organic polymers, since said rare-earth metal compounds are usually insulators.

It is also possible, however, to use triplet emitter complexes with ligands which themselves have transport properties. Examples of such ligands are the carboxylic acids of diphenylamine or triphenylamine, such as diphenylamine-2-carboxylic acid or diphenylamine-2,2-dicarboxylic acid.

Besides the n- and p-conductive organic materials which form the matrix for the metallo-organic triplet emitter complex, the organic electroluminescent component may contain other n- and p-conductive materials in the matrix layer or in separate layers.

Molecularly doped organic polymers, intrinsically conductive organic polymers, i.e. polymers with inherent conductivity, or conductive organic monomers are used as further p-conductive materials for the p-conductive layer. Poly(p-phenylene vinylene) and derivatives thereof or poly(methylphenyl silane) are also suitable for p-conductive layers without electroluminescing additives. In layers with electroluminescing additives, however, their capacity for nonradiative transitions from the T₁ state causes perturbation.

For example, triphenylamine with a T₁^{P} of about 24500 cm⁻¹, tritolueneamine with a T₁^{P} of about 24000 cm⁻¹ or triphenyldiamine with a T₁^{P} of about 18000 cm⁻¹ may be used as further p-conductive organic monomers for the present invention.

Intrinsically conductive organic monomers and polymers, or polymers provided with molecular doping, are likewise used as further conductive organic materials for the layer with n-type conduction. 3,4,9,10-perylene-tetracarboxy-bis-benzimidazole, 2-(4-biphenylyl)-5-(tert.-butylphenyl)-1,3,4-oxadiazole (butyl-PBD), 2-(4-biphenylyl)-5-phenyl-1,3,4-oxadiazole (PBD) with a T¹ₙ of about 2.54 eV (20500 cm⁻¹) or 2,5-diphenyl-1,3,4-oxadiazole (PPD) with a T¹ₙ of about 2.91 eV (23500 cm⁻¹) and 8-hydroxyquinoline aluminum (Alq) are intrinsically conductive organic monomers which are suitable for the electron-transporting layer.

A polymethyl methacrylate treated with 8-hydroxyquinoline aluminum (Alq) may be used as a further n-conductive molecularly doped organic polymer.

Further molecularly doped organic polymers which may be used according to the invention consist, for example, of polymethyl methacrylate (PMMA), polystyrene or bisphenol A-polycarbonate as the matrix, with doping by oxadiazoles such as 2-(4-biphenylyl)-5-(tert.-butyl-phenyl)-1,3,4-oxadiazole (butyl-PBD) (T₁ × 2.54 eV (20500 cm⁻¹) ) and 2,5-diphenyl-1,3,4-oxadiazole (PPD) (T₁× 2.90 eV (23400 cm⁻¹) ) or triazoles such as 3,5-diphenyl-1,2,4-triazole.

The p- and n-conductive layers may be applied from solution, vapor deposited or polymerized in situ.

If they are capable of evaporation, the triplet emitter complexes may be sublimed on, optionally together with the electrically conductive organic monomers of the matrix.

If they are intended to be applied together with an electrically conductive organic polymer, it is necessary to dissolve both components in a common solvent or solvent mixture in order to form a coating solution.

A DC voltage, typically a few volts, is applied to the two electrodes during operation. The first electrode is then at a positive potential (anode), and the second electrode is at a negative potential (cathode).

During operation, the following processes take place in the matrix which contains a triplet emitter complex:

From the electrodes, holes are injected as positive charge carriers and electrons are injected as negative charge carriers, and these recombine on molecules of the matrix and hence electronically excite them. Owing to the spin statistics, 25% of small molecules (in contrast to many polymers) are excited in the singlet state, from which they can convert to the ground state by emitting light (fluorescence). In 75% of the recombinations, however, the excitation takes place into the lowest-energy triplet state from which the radiative transition to the ground state is forbidden, which leads to very long radiative lifetimes. The light emission from the triplet level, which is referred to as phosphorescence, is usually observed only when the substance is cooled to nitrogen temperature. Owing to a mixture of singlet and triplet states, radiative transitions from the triplet state take place even at room temperature in the triplet emitter complexes. The lifetime of this state is typically in the range of from one microsecond to one millisecond, however, and is therefore very much longer than that of transitions from the singlet level.

During this comparatively long time, the energy can be transferred to neighboring molecules if their triplet level is either lower than that of the starting molecule or - if it is higher - a transition is possible by means of thermal activation.

Once the triplet energy has been transferred to other molecules, there is a high probability that it will be transferred again, and finally be lost from the light emission. In order to fix the triplet energy in the emitter layer, according to the invention the matrix therefore contains conductive organic materials with a high triplet state.

In order to substantially preclude any energy transfer at room temperature, according to the invention the triplet state of the neighboring molecules is ≥2000 wave numbers higher than that of the recombination molecule.

Both large-area luminous surfaces and high-resolution displays can be produced by using organic electroluminescent components according to the invention.

## Claims

1. An organic electroluminescent component having a layer composite, which comprises
a) a substrate layer (1),
b) a first transparent electrode layer (4),
c) a mixing layer (6,7,8) having
c.1) a matrix of a conductive organic material with one or more singlet states and one or more triplet states, selected from the group: p-conductive and n-conductive materials,
c.2) in this matrix, a light-emitting material which comprises a metallo-organic complex compound with an emissive triplet state, and
d) a second electrode (5),
wherein the lowest-energy triplet state of the conductive organic material is higher than the emissive triplet state of the metallo-organic complex compound by an energy difference Eₜ. **characterised in that** the conductive organic material comprises a structural element which is a benzene ring substituted with an organic substituent R- in the meta position.

2. An organic electroluminescent component as claimed in claim 1, **characterized in that** the energy difference is Eₜ ≥ 0.248 EV(2000 cm⁻¹)

3. An organic electroluminescent component as claimed in claim 1, **characterized in that** the conductive organic material comprises a structural element which is a biphenyl substituted with an organic substituent R- in the meta position.

4. An organic electroluminescent component as claimed in claim 3 **characterized in that** the structural element is a biphenyl multiply substituted in the meta position.

5. An organic electroluminescent component as claimed in claim 1, **characterized in that** that the conductive organic material is selected from the group: molecularly doped organic polymers, semiconducting conjugated polymers, intrinsically conductive organic polymers, oligomers, and conductive organic monomers, and mixtures thereof.

6. An organic electroluminescent component as claimed in claims 1 and 3 **characterized in that** the substituent R- is selected from the group of organic substituents:
phenyl and derivatives, arylamine and derivatives, oxadiazole and derivatives, triazole and derivatives, triphenylamine and derivatives, carbazole and derivatives, oxadiazoles and derivatives, triazoles and derivatives, triazines and derivatives, fluorenes and derivatives, hexaphenylbenzene and derivatives, phenanthroline and derivatives, pyridine and derivatives.

## Patentansprüche

1. Organisches, elektrolumineszierendes Bauelement mit einem Schichtenverbund, der umfasst:
a) eine Substratschicht (1),
b) eine erste transparente Elektrodenschicht (4),
c) eine Mischschicht (6,7,8) mit
c.1) einer Matrix aus einem leitenden, organischen Material mit einem oder mehreren Singulettzuständen und einem oder mehreren Triplettzuständen, ausgewählt aus der Gruppe: p-leitende und n-leitende Materialien,
c.2) in dieser Matrix, einem Licht emittierenden Material, das eine metallorganische Komplexverbindung mit einem emissiven Triplettzustand umfasst, sowie
d) eine zweite Elektrode (5),
wobei der energetisch niedrigste Triplettzustand des leitenden, organischen Materials um eine Energiedifferenz Eₜ höher als der emissive Triplettzustand der metallorganischen Komplexverbindung ist,
**dadurch gekennzeichnet, dass** das leitende, organische Material ein Strukturelement umfasst, das ein mit einem organischen Substituenten R - in der Meta-Position substituierter Benzolring ist.

2. Organisches, elektrolumineszierendes Bauelement nach Anspruch 1, **dadurch gekennzeichnet, dass** die Energiedifferenz Eₜ ≥ 0,248 EV(2000 cm⁻¹) ist.

3. Organisches, elektrolumineszierendes Bauelement nach Anspruch 1, **dadurch gekennzeichnet, dass** das leitende, organische Material ein Strukturelement umfasst, das ein mit einem organischen Substituenten R- in der Meta-Position substituiertes Biphenyl ist.

4. Organisches, elektrolumineszierendes Bauelement nach Anspruch 3, **dadurch gekennzeichnet, dass** das Strukturelement ein in der Meta-Position mehrfach substituiertes Biphenyl ist.

5. Organisches, elektrolumineszierendes Bauelement nach Anspruch 1, dadurch gekennzeichnet, dass das leitende, organische Material aus der Gruppe, umfassend:
molekular dotierte, organische Polymere, halbleitende, konjugierte Polymere, intrinsisch leitfähige, organische Polymere, Oligomere und leitfähige, organische Monomere sowie Mischungen daraus, ausgewählt wird.

6. Organisches, elektrolumineszierendes Bauelement nach den Ansprüchen 1 und 3, **dadurch gekennzeichnet, dass** der Substituent R- aus der Gruppe von organischen Substituenten, umfassend: Phenyl und Derivate, Arylamin und Derivate, Oxadiazol und Derivate, Triazol und Derivate, Triphenylamin und Derivate, Carbazol und Derivate, Oxadiazole und Derivate, Triazole und Derivate, Triazine und Derivate, Fluorene und Derivate, Hexaphenylbenzol und Derivate, Phenanthrolin und Derivate, Pyridin und Derivate, ausgewählt wird.

## Revendications

1. Composant électroluminescent organique comprenant un composite en couches, qui comprend :
a) une couche de substrat (1),
b) une première couche d'électrode transparente (4),
c) une couche de mélange (6, 7, 8) comprenant
c.1) une matrice d'un matériau organique conducteur présentant un ou plusieurs états singulets et un ou plusieurs états triplets, sélectionné parmi le groupe composé de : matériaux conducteurs p et matériaux conducteurs n,
c.2) dans cette matrice, un matériau émetteur de lumière qui comprend un composé complexe organométallique présentant un état triplet émissif, et
d) une seconde électrode (5),
dans lequel l'état triplet à plus faible énergie du matériau organique conducteur est supérieur à l'état triplet émissif du composé complexe organométallique d'une différence d'énergie Eₜ,
**caractérisé en ce que** le matériau organique conducteur comprend un élément structural qui est un anneau benzénique substitué avec un substituant organique R-dans la position méta.

2. Composant électroluminescent organique selon la revendication 1, **caractérisé en ce que** la différence d'énergie est Eₜ ≥ 0,248 EV (2000 cm⁻¹).

3. Composant électroluminescent organique selon la revendication 1, **caractérisé en ce que** le matériau organique conducteur comprend un élément structural qui est un biphényle substitué avec un substituant organique R- dans la position méta.

4. Composant électroluminescent organique selon la revendication 3, **caractérisé en ce que** l'élément structural est un biphényle multicouches substitué dans la position méta.

5. Composant électroluminescent organique selon la revendication 1, **caractérisé en ce que** le matériau organique conducteur est sélectionné parmi le groupe composé de : polymères organiques moléculairement dopés, polymères conjugués semiconducteurs, polymères organiques à conductivité intrinsèque, oligomères et monomères organiques conducteurs et mélanges de ceux-ci.

6. Composant électroluminescent organique selon les revendications 1 et 3, **caractérisé en ce que** le substituant R- est sélectionné parmi le groupe de substituants organiques suivants : phényle et dérivés, arylamine et dérivés, oxadiazole et dérivés, triazole et dérivés, triphénylamine et dérivés, carbazole et dérivés, oxadiazoles et dérivés, triazoles et dérivés, triazines et dérivés, fluorènes et dérivés, hexaphénylbenzène et dérivés, phénanthroline et dérivés, pyridine et dérivés.
